# EUROPEAN PATENT APPLICATION

(11) **EP 4 822 485 A1**
(43) Date of publication of application: **14.10.2026**
(21) Application number: 24899603.5
(22) Date of filing: 18.11.2024
(51) Int. Cl.: G06F 1/04, H03B 5/08, H03B 5/04

(54) **CLOCK SIGNAL TEMPERATURE DRIFT CORRECTION METHOD AND CIRCUIT, CHIP AND ELECTRONIC DEVICE**

(30) Priority: 04.12.2023 CN 202311639080
(71) Applicant: Chipsea Technologies (Shenzhen) Corp., Shenzhen, Guangdong 518000 (CN)
(72) Inventor: LI, Xiao, Shenzhen, Guangdong 518000 (CN)
(74) Representative: Berggren Oy
(86) International application number: PCT/CN2024/132775
(87) International publication number: WO 2025/118961

(57) **Abstract**

Embodiments of the present application provide a clock signal temperature drift correction method, a circuit, a chip, and an electronic device (100). The clock signal temperature drift correction method includes: a step (S201) of determining if a temperature drift is presented in a first clock signal (CLK1) and a second clock signal (CLK2); and a step (S202) of when a temperature drift is presented in the first clock signal (CLK1) and the second clock signal (CLK2), adjusting a frequency of the first clock signal (CLK1) and a frequency of the second clock signal (CLK2) so that the frequency of the first clock signal (CLK1) and the frequency of the second clock signal (CLK2) maintain a preset relationship.

## Description

The present application claims priority to the Chinese patent application No. 202311639080.0 with the invention title "CLOCK SIGNAL TEMPERATURE DRIFT CORRECTION METHOD, CIRCUIT, CHIP AND ELECTRONIC DEVICE", filed with the China National Intellectual Property Administration (CNIPA) on December 4, 2023 the entire contents of which are incorporated herein by reference.

### FIELD OF INVENTION

The present application relates to the field of electronic technology, and in particular to a clock signal temperature drift correction method, circuit, chip, and electronic device.

### BACKGROUND OF INVENTION

Currently, a clock signal serves as a foundation for sequential logic and is used to determine when states in logic units are updated, thereby ensuring synchronized operation of related electronic components. However, when an ambient temperature of a clock circuit changes (for example, due to heat generated by a chip), a period and a frequency of the clock signal vary, causing timing errors or malfunctions in sequential logic circuits.

In the related art, to reduce temperature drift of the clock signal, a conventional approach involves minimizing temperature drift of electronic elements in the clock circuit. For example, in a classic RC oscillator clock, elements affecting a clock period include a resistor and a capacitor, so reducing temperature drift of the resistor and/or the capacitor can weaken the temperature drift of the clock signal. In the related art, a temperature variation value may also be measured by a temperature sensor, and then a period of the clock signal is corrected according to a relationship between temperature and frequency based on the temperature variation value. However, the above approaches are significantly affected by objective factors such as circuit fabrication processes and accuracy of the temperature sensor, and the temperature drift of the clock signal cannot be completely avoided.

### SUMMARY OF INVENTION

### Technical Problem

Embodiments of the present application provide a clock signal temperature drift correction method, circuit, chip, and electronic device to address the temperature drift of the clock signal.

### Technical Solution

The technical solution of the present application is as follows:

In a first aspect, the present application provides a clock signal temperature drift correction method applied to a clock signal generation circuit, wherein the clock signal generation circuit comprises a first clock module generating a first clock signal and a second clock module generating a second clock signal, and the method comprises:
determining if a temperature drift is presented in the first clock signal and the second clock signal; and
when the temperature drift is presented in the first clock signal and the second clock signal, adjusting a frequency of the first clock signal and a frequency of the second clock signal so that the frequency of the first clock signal and the frequency of the second clock signal maintain a predetermined relationship;
wherein a first temperature coefficient of the first clock signal is different from a second temperature coefficient of the second clock signal, and when the frequency of the first clock signal and the frequency of the second clock signal maintain the predetermined relationship, the frequency of the first clock signal is equal to a first set frequency at a set temperature, and the frequency of the second clock signal is equal to a second set frequency at the set temperature.

In a second aspect, the present application provides a clock signal temperature drift correction circuit, comprising:
a clock signal generation circuit, wherein the clock signal generation circuit comprises a first clock module generating a first clock signal and a second clock module generating a second clock signal; and
a temperature drift correction circuit, wherein the temperature drift correction circuit is configured to determine if a temperature drift is presented in the first clock signal and the second clock signal, and when the temperature drift is presented in the first clock signal and the second clock signal, the temperature drift correction circuit adjusts a frequency of the first clock signal and a frequency of the second clock signal so that the frequency of the first clock signal and the frequency of the second clock signal maintain a predetermined relationship;
wherein a first temperature coefficient of the first clock signal is different from a second temperature coefficient of the second clock signal, and when the frequency of the first clock signal and the frequency of the second clock signal maintain the predetermined relationship, the frequency of the first clock signal is equal to a first set frequency at a set temperature, and the frequency of the second clock signal is equal to a second set frequency at the set temperature.

In a third aspect, the present application provides a chip comprising the clock signal temperature drift correction circuit according to the second aspect.

In a fourth aspect, the present application provides an electronic device comprising a memory and a processor, wherein the memory stores a computer program, and the processor is configured to execute the computer program in the memory to perform steps in the clock signal temperature drift correction method according to the first aspect.

### Beneficial Effects

In the clock signal temperature drift correction method provided by embodiments of the present application, since a first temperature coefficient of a first clock signal is different from a second temperature coefficient of a second clock signal, when a temperature change causes variations in a frequency of the first clock signal and a frequency of the second clock signal, a relationship between the frequency of the first clock signal and the frequency of the second clock signal varies. For example, when the first temperature coefficient exceeds the second temperature coefficient, a frequency difference/ratio between the first clock signal and the second clock signal gradually increases as the temperature rises. Therefore, by ensuring that the frequency of the first clock signal and the frequency of the second clock signal maintain a predetermined relationship again after a temperature drift is presented, the frequency of the first clock signal can return to a first set frequency at a set temperature, and the frequency of the second clock signal can return to a second set frequency at the set temperature. This allows the first clock signal and the second clock signal to return to corresponding set frequencies after an ambient temperature change even if a temperature drift is presented, to ultimately minimize/eliminate temperature drift for the first clock signal and the second clock signal, and avoiding the temperature drift of the clock signal that cannot be completely eliminated in conventional approaches due to objective factors such as circuit fabrication processes and accuracy of temperature sensors.

These and other aspects of the present application will become more apparent from the description of the following embodiments.

### DESCRIPTION OF DRAWINGS

To illustrate technical solutions in embodiments of the present application more clearly, accompanying drawings required for describing the embodiments are briefly introduced below. Evidently, the drawings described below represent only some embodiments of the present application. For those skilled in the art, other drawings may be obtained based on these drawings without creative efforts.
FIG. 1 shows a schematic diagram of an application scenario of a clock signal temperature drift correction method provided by an embodiment of the present application.
FIG. 2 shows a flow diagram of a clock signal temperature drift correction method provided by an embodiment of the present application.
FIG. 3 shows a schematic diagram of a relationship between a clock signal frequency and temperature provided by an embodiment of the present application.
FIG. 4 shows a flow diagram of adjusting a clock signal frequency provided by an embodiment of the present application.
FIG. 5 shows another flow diagram of adjusting a clock signal frequency provided by an embodiment of the present application.
FIG. 6 shows another flow diagram of adjusting a clock signal frequency provided by an embodiment of the present application.
FIG. 7 shows a schematic diagram of a process of adjusting a frequency of a first clock signal provided by an embodiment of the present application.
FIG. 8 shows another flow diagram of adjusting a clock signal frequency provided by an embodiment of the present application.
FIG. 9 shows a schematic diagram of a process of adjusting a frequency of a second clock signal provided by an embodiment of the present application.
FIG. 10 shows a schematic diagram of a process of adjusting frequencies of a first clock signal and a second clock signal provided by an embodiment of the present application.
FIG. 11 shows a block diagram of a clock signal temperature drift correction circuit provided by an embodiment of the present application.
   electronic device 100, clock circuit 10, first clock module 11, second clock module 12, clock control module 20;
   clock signal temperature drift correction circuit 1000, clock signal generation circuit 1001, temperature drift correction circuit 1002.

### DETAILED DESCRIPTION OF PREFERRED EMBODIMENTS

Embodiments of the present application are described in detail below, with examples thereof illustrated in accompanying drawings, wherein identical or similar reference numerals denote identical or similar elements or elements having identical or similar functions throughout. The embodiments described below with reference to the drawings are exemplary and are intended only to explain the present application, without imposing limitations thereon.

To enable those skilled in the art to better understand solutions of the present application, technical solutions in embodiments of the present application are clearly and completely described below in conjunction with accompanying drawings in the embodiments. Evidently, the described embodiments represent only a portion of embodiments of the present application, not all embodiments. Based on the embodiments in the present application, all other embodiments obtained by those skilled in the art without creative efforts fall within the scope of protection of the present application.

In embodiments of the present application, it should be noted that relational terms such as "first" and "second" are used merely to distinguish one entity or operation from another entity or operation and do not necessarily require or imply any actual relationship or order between these entities or operations.

Moreover, terms "comprise," "include," or any other variants thereof are intended to cover non-exclusive inclusion, so that a process, method, article, or device comprising a series of elements includes not only those elements but also other elements not explicitly listed or elements inherent to such process, method, article, or device. Without further limitations, an element defined by the phrase "comprising a ... " does not exclude the presence of additional identical elements in the process, method, article, or device comprising the element.

In the description of embodiments of the present application, terms such as "example" or "for example" are used to indicate illustration, exemplification, or description. Any embodiment or design scheme described as "example" or "for example" in embodiments of the present application should not be construed as more preferred or advantageous over other embodiments or design schemes. Use of terms such as "example" or "for example" aims to present related concepts in a clear manner.

Additionally, in embodiments of the present application, "a plurality of" refers to two or more. In view of this, "a plurality of" in embodiments of the present application may also be understood as "at least two." "At least one" may be understood as one or more, for example, one, two, or more. For example, including at least one means including one, two, or more, without limiting which ones are included. For instance, including at least one of A, B, and C means including A, B, C, A and B, A and C, B and C, or A and B and C.

It should be noted that in embodiments of the present application, "and/or" describes an association relationship of associated objects and indicates three possible relationships. For example, A and/or B may indicate: A alone, both A and B, or B alone. Additionally, the character "/", unless otherwise specified, generally indicates an "or" relationship between associated objects.

It should be pointed out that in embodiments of the present application, "connection" may be understood as electrical connection, and connection between two electrical elements may be direct or indirect through one or more other electrical elements. For example, connection between A and B may mean direct connection between A and B or indirect connection between A and B via one or more other electrical elements.

Currently, a clock signal serves as a foundation for sequential logic and is used to determine when states in logic units are updated, thereby ensuring synchronized operation of related electronic components. However, when an ambient temperature of a clock circuit changes (for example, due to heat generated by a chip), a period and a frequency of the clock signal vary, causing timing errors or malfunctions in sequential logic circuits.

In the related art, clock signal temperature drift elimination solutions mainly include two implementation approaches:
1. Minimizing temperature drift of electronic elements in the clock circuit. For example, in a classic RC oscillator clock, elements affecting a clock period include a resistor and a capacitor, so reducing temperature drift of the resistor and/or the capacitor can weaken the temperature drift of the clock signal.
2. Measuring temperature via a temperature sensor and then correcting a clock period by a predetermined proportion or offset based on the temperature and a preset temperature drift calibration code value or conversion formula to eliminate the temperature drift of the clock signal.

However, the first approach above is limited by circuit fabrication processes and cannot accurately calibrate the temperature drift of the clock signal, while the second approach requires a high-precision temperature sensor, logic circuit, and pre-calibrated parameters, incurring high cost and remaining limited by accuracy of the temperature sensor, thus also failing to accurately calibrate the temperature drift of the clock signal.

To address this, the present application provides a clock signal temperature drift correction method, circuit, chip, and electronic device, which are described separately below.

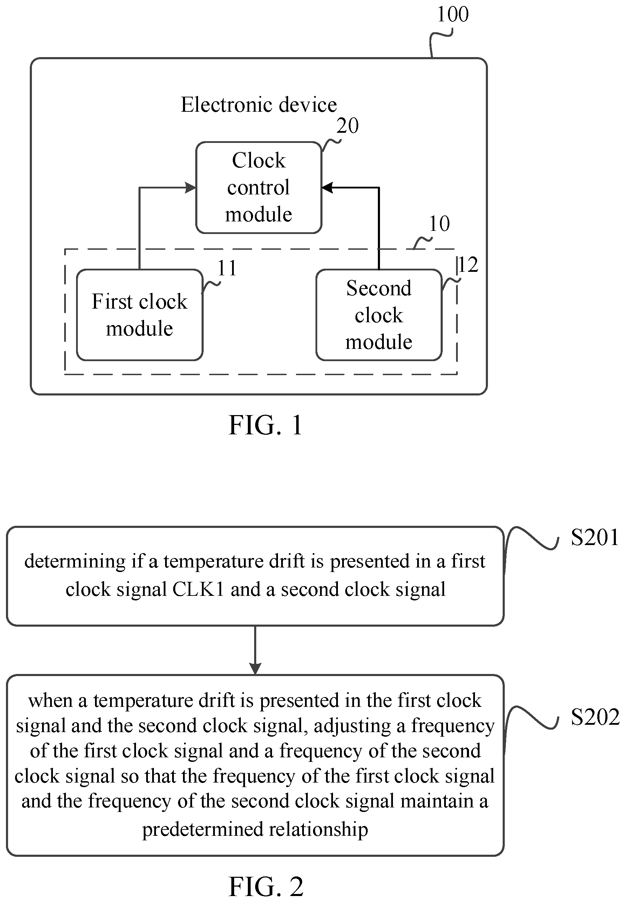

First, with reference to FIG. 1, FIG. 1 shows a schematic diagram of an application scenario of the clock signal temperature drift correction method in an embodiment of the present application. The clock signal temperature drift correction method provided by the present application can be applied in an electronic device 100 shown in FIG. 1, wherein the electronic device 100 comprises a clock circuit 10 and a clock control module 20, and the clock circuit 10 comprises a first clock module 11 generating a first clock signal and a second clock module 12 generating a second clock signal. Specifically, the first clock module 11 and the second clock module 12 may each be any one of a resistor-capacitor (RC) oscillator, an inductance-capacitance (LC) oscillator, or a crystal oscillator. The RC oscillator includes, but is not limited to, a bridge oscillator, an RC phase-shift oscillator, or a double-T oscillator. The LC oscillator includes, but is not limited to, a mutual-inductance coupled oscillator, an inductive feedback oscillator, or a capacitive feedback oscillator. The crystal oscillator includes, but is not limited to, a parallel crystal oscillator or a series crystal oscillator.

The clock control module 20 refers to a module that receives the first clock signal and/or the second clock signal. After receiving the first clock signal and/or the second clock signal, the clock control module 20 can utilize the first clock signal and/or the second clock signal to achieve stable operation of related circuits, for example, clock control for displaying images on a display panel, synchronization of data frames, synchronized network communication, ensuring correctness of data transmission, achieving timing control, and synchronizing operations of various modules in a chip. As an example, the clock control module 20 may refer to a chip in the electronic device that receives a base clock signal, enabling the chip to operate based on the base clock signal. As another example, the clock control module 20 may refer to a display control circuit (for example, a GOA circuit) of a display panel in the electronic device, enabling the display control circuit to refresh displayed images after receiving the clock signal.

Continuing to refer to FIG. 2, FIG. 2 shows a flow diagram of the clock signal temperature drift correction method in an embodiment of the present application, wherein the clock signal temperature drift correction method comprises:
Step S201: determining if a temperature drift is presented in a first clock signal CLK1 and a second clock signal CLK2;
In some embodiments of the present application, an ambient temperature of the first clock module 11 and/or the second clock module 12 can be detected. When the ambient temperature changes beyond a certain value (for example, a temperature rise of 5°C. or a temperature drop of 5°C.), a temperature drift can be determined to have been presented in the first clock signal CLK1 and the second clock signal CLK2. Conversely, no temperature drift can be determined in the first clock signal CLK1 and the second clock signal CLK2.

It should be noted that in the present application, detecting the ambient temperature of the first clock module 11 and/or the second clock module 12 serves merely to determine if a temperature drift is presented in the first clock signal CLK1 and the second clock signal CLK2. Thus, only a rough detection of the ambient temperature of the first clock module 11 and/or the second clock module 12 is required, without needing a high-precision value of the ambient temperature of the first clock module 11 and/or the second clock module 12. In other words, the implementation of detecting the ambient temperature of the first clock module 11 and/or the second clock module 12 in the present application imposes no requirement on accuracy of a temperature sensor, and a high-precision temperature sensor need not be used.

In some embodiments of the present application, a frequency of the first clock signal CLK1 and/or the second clock signal CLK2 can be detected, and then if the frequency of the first clock signal CLK1 and/or the second clock signal CLK2 deviates from a set frequency by a certain value is determined to judge if a temperature drift is presented in the first clock signal CLK1 and the second clock signal CLK2. For example, an actual frequency of the first clock signal CLK1 is detected as 4.1 MHz, while a first set frequency of the first clock signal CLK1 is 4 MHz, and a difference between the actual frequency and the first set frequency of the first clock signal CLK1 is greater than or equal to 0.1 MHz, so a temperature drift can be determined to have been presented in the first clock signal CLK1 and the second clock signal CLK2.

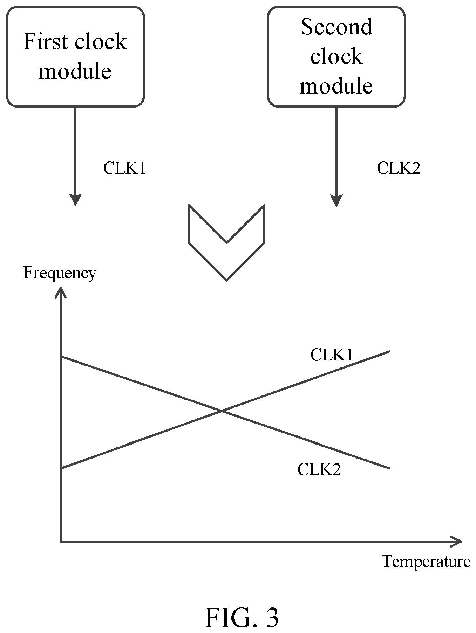

In some embodiments of the present application, frequencies of the first clock signal CLK1 and the second clock signal CLK2 can also be detected, and then a frequency difference between the first clock signal CLK1 and the second clock signal CLK2 is calculated. If a temperature drift is presented in the first clock signal CLK1 and the second clock signal CLK2 is determined based on an actual frequency difference and a set frequency difference between the first clock signal CLK1 and the second clock signal CLK2, wherein the set frequency difference refers to a difference between a set frequency of the first clock signal CLK1 and a set frequency of the second clock signal CLK2 at a set temperature, that is, the set frequency difference is equal to the difference between the first set frequency and the second set frequency. Specifically, with reference to FIG. 3, FIG. 3 shows a schematic diagram of a relationship between a clock signal frequency and temperature in an embodiment of the present application. According to a relationship formula between frequency and temperature: $f 1 = f 01 * \left(1+TC1*\left(T0-t\right)\right)$ $f 2 = f 02 * \left(1+TC2*\left(T0-t\right)\right)$
wherein T0 represents the set temperature (for example, 25°C.), t represents an actual ambient temperature, f1 represents a frequency of the first clock signal CLK1 at the actual ambient temperature, f2 represents a frequency of the second clock signal CLK2 at the actual ambient temperature, f01 represents the first set frequency of the first clock signal CLK1 at the set temperature, f02 represents the second set frequency of the second clock signal CLK2 at the set temperature, TC1 represents a first temperature coefficient of the first clock signal CLK1, and TC2 represents a second temperature coefficient of the second clock signal CLK2.

Thus, a frequency difference between the first clock signal CLK1 and the second clock signal CLK2 at the actual ambient temperature maintains the following relationship: $f 1 - f 2 = f 01 * \left(1+TC1*\left(T0-t\right)\right) - f 02 * \left(1+TC2*\left(T0-t\right)\right)$

Since the first temperature coefficient of the first clock signal CLK1 is different from the second temperature coefficient of the second clock signal CLK2, the frequency difference between the first clock signal CLK1 and the second clock signal CLK2 varies after the actual ambient temperature changes. For example, the first set frequency of the first clock signal CLK1 is 4 MHz, the second set frequency of the second clock signal CLK2 is 48 MHz, and the frequency difference between the first clock signal CLK1 and the second clock signal CLK2 at the set temperature is 44 MHz. After the actual ambient temperature deviates from the set temperature, the frequency difference between the first clock signal CLK1 and the second clock signal CLK2 may change to 44.11 MHz. By determining if the frequency difference between the first clock signal CLK1 and the second clock signal CLK2 exceeds a corresponding threshold range (for example, 43.9 MHz to 44.1 MHz), if a temperature drift is presented in the first clock signal CLK1 and the second clock signal CLK2 can be judged.

In some embodiments of the present application, if a temperature drift is presented in the first clock signal CLK1 and the second clock signal CLK2 can also be determined based on a ratio of the actual frequencies and a set frequency ratio between the first clock signal CLK1 and the second clock signal CLK2, wherein the set frequency ratio refers to a ratio of a set frequency of the first clock signal CLK1 to a set frequency of the second clock signal CLK2 at the set temperature, that is, the set frequency ratio is equal to the ratio of the first set frequency to the second set frequency. Similarly, with reference to FIG. 3, according to the above relationship formula between frequency and temperature, a frequency ratio between the first clock signal CLK1 and the second clock signal CLK2 at the actual ambient temperature maintains the following relationship: $\frac{f 1}{f 2} = \frac{f 01 ∗ \left(1+TC1∗\left(T0-t\right)\right)}{f 02 ∗ \left(1+TC2∗\left(T0-t\right)\right)}$

Since the first temperature coefficient of the first clock signal CLK1 is different from the second temperature coefficient of the second clock signal CLK2, the frequency ratio between the first clock signal CLK1 and the second clock signal CLK2 also varies after the actual ambient temperature changes. For example, the first set frequency of the first clock signal CLK1 is 4 MHz, the second set frequency of the second clock signal CLK2 is 48 MHz, and the set frequency ratio between the first clock signal CLK1 and the second clock signal CLK2 at the set temperature is 12. After the actual ambient temperature deviates from the set temperature, the frequency difference between the first clock signal CLK1 and the second clock signal CLK2 may change to 12.06. By determining if the frequency ratio between the first clock signal CLK1 and the second clock signal CLK2 exceeds a corresponding threshold range (for example, 11.95 to 12.05), if a temperature drift is presented in the first clock signal CLK1 and the second clock signal CLK2 can be judged.

It should be noted that since a frequency of a clock signal is inversely proportional to a period thereof, implementations in embodiments of the present application involving frequency can equivalently be replaced by implementations involving period, and implementations involving period should be regarded as adopting the implementations concerning frequency in the present application. For example, a period of the first clock signal CLK1 and/or the second clock signal CLK2 can be detected, and then if the period of the first clock signal CLK1 and/or the second clock signal CLK2 deviates from a set period by a certain value is determined to judge if a temperature drift is presented in the first clock signal CLK1 and the second clock signal CLK2. This implementation of detecting the period of the first clock signal CLK1 and/or the second clock signal CLK2 should be regarded as identical to the implementation of detecting the frequency of the first clock signal CLK1 and/or the second clock signal CLK2 in the present application.

Step S202: when a temperature drift is presented in the first clock signal CLK1 and the second clock signal CLK2, adjusting a frequency of the first clock signal CLK1 and a frequency of the second clock signal CLK2 so that the frequency of the first clock signal CLK1 and the frequency of the second clock signal CLK2 maintain a predetermined relationship.

When a temperature drift is determined to have been presented in the first clock signal CLK1 and the second clock signal CLK2, a frequency of the first clock signal CLK1 and a frequency of the second clock signal CLK2 can be adjusted so that the frequency of the first clock signal CLK1 and the frequency of the second clock signal CLK2 maintain a predetermined relationship. When the frequency of the first clock signal CLK1 and the frequency of the second clock signal CLK2 maintain the predetermined relationship, the frequency of the first clock signal CLK1 is equal to a first set frequency at a set temperature, and the frequency of the second clock signal CLK2 is equal to a second set frequency at the set temperature. This allows the first clock signal CLK1 and the second clock signal CLK2 to return to corresponding set frequencies after an ambient temperature change even if a temperature drift is presented, to ultimately minimize/eliminate temperature drift for the first clock signal CLK1 and the second clock signal CLK2, and avoiding the temperature drift of the clock signal that cannot be completely eliminated in conventional approaches due to objective factors such as circuit fabrication processes and accuracy of temperature sensors.

It should be noted that numerical parameters used in the description and claims of the present application are approximate values, and these approximate values may vary according to characteristics required by individual embodiments. For example, the first set frequency and the second set frequency referred to in the present application may allow certain frequency variations around the first set frequency and the second set frequency. When the frequency of the first clock signal CLK1 and the frequency of the second clock signal CLK2 maintain the predetermined relationship, the frequency of the first clock signal CLK1 falls within a range of the first set frequency ±0.1%, and the frequency of the second clock signal CLK2 falls within a range of the second set frequency ±0.1%. Understandably, variation ranges of numerical parameters used in the description and claims of the present application can be adjusted according to actual needs. For example, the first set frequency and the second set frequency can also be adjusted according to actual oscillator and pulse signal precision requirements, without specific limitations herein in the present application.

In some embodiments of the present application, a predetermined relationship may refer to an actual frequency difference between the first clock signal CLK1 and the second clock signal CLK2 equal to a set frequency difference. Since the first temperature coefficient of the first clock signal CLK1 is different from the second temperature coefficient of the second clock signal CLK2, the frequency difference between the first clock signal CLK1 and the second clock signal CLK2 varies after an actual ambient temperature changes. Therefore, after a temperature drift is presented, by readjusting the actual frequency difference between the first clock signal CLK1 and the second clock signal CLK2 to the set frequency difference, the frequency of the first clock signal CLK1 can return to the first set frequency at the set temperature, and the frequency of the second clock signal can return to the second set frequency at the set temperature. For example, in the above embodiment where the frequency difference between the first clock signal CLK1 and the second clock signal CLK2 at the set temperature is 44 MHz, and after the actual ambient temperature deviates from the set temperature the frequency difference between the first clock signal CLK1 and the second clock signal CLK2 may change to 44.11 MHz, a frequency of the first clock signal CLK1 and a frequency of the second clock signal CLK2 can be adjusted so that the frequency difference between the first clock signal CLK1 and the second clock signal CLK2 returns to 44 MHz.

In some embodiments of the present application, a predetermined relationship may refer to a ratio of the actual frequency of the first clock signal CLK1 and the actual frequency of the second clock signal CLK2 equal to a set frequency ratio. Similarly, since the first temperature coefficient of the first clock signal CLK1 is different from the second temperature coefficient of the second clock signal CLK2, the frequency ratio between the first clock signal CLK1 and the second clock signal CLK2 also varies after an actual ambient temperature changes. Therefore, after a temperature drift is presented, by readjusting the frequency ratio between the first clock signal CLK1 and the second clock signal CLK2 to the set frequency ratio, the frequency of the first clock signal CLK1 can return to the first set frequency at the set temperature, and the frequency of the second clock signal can return to the second set frequency at the set temperature. For example, in the above embodiment where the frequency ratio between the first clock signal CLK1 and the second clock signal CLK2 at the set temperature is 12, and after the actual ambient temperature deviates from the set temperature the frequency difference between the first clock signal CLK1 and the second clock signal CLK2 may change to 12.06, a frequency of the first clock signal CLK1 and a frequency of the second clock signal CLK2 can be adjusted so that the frequency ratio between the first clock signal CLK1 and the second clock signal CLK2 returns to 12.

Understandably, a predetermined relationship may also refer to both a ratio of the actual frequency of the first clock signal CLK1 and the actual frequency of the second clock signal CLK2 equal to a set frequency ratio and an actual frequency difference between the first clock signal CLK1 and the second clock signal CLK2 equal to a set frequency difference.

In some embodiments of the present application, for example, in an embodiment where the first clock module 11 and the second clock module 12 comprise RC oscillators, electronic elements related to temperature coefficients in an RC oscillator can be adjusted to modify a frequency of the first clock signal CLK1 and a frequency of the second clock signal CLK2. For example, a resistance value of a resistor in the RC oscillator can be changed. As another example, a capacitance value of a capacitor in the RC oscillator can be changed. As yet another example, a resistance value of a resistor and a capacitance value of a capacitor in the RC oscillator can be changed.

In some embodiments of the present application, for example, in an embodiment where the first clock module 11 and the second clock module 12 comprise LC oscillators, electronic elements related to temperature coefficients in an LC oscillator can be adjusted to modify a frequency of the first clock signal CLK1 and a frequency of the second clock signal CLK2. For example, a capacitance value of a capacitor in the LC oscillator can be changed. As another example, an inductance value of an inductor in the LC oscillator can be changed. As yet another example, a capacitance value of a capacitor and an inductance value of an inductor in the RC oscillator can be changed.

In some embodiments of the present application, for example, in an embodiment where the first clock module 11 and the second clock module 12 comprise crystal oscillators, electronic elements related to temperature coefficients in a crystal oscillator can be adjusted to modify a frequency of the first clock signal CLK1 and a frequency of the second clock signal CLK2. For example, a capacitance value of a crystal in the crystal oscillator can be changed. As another example, an inductance value of a crystal in the crystal oscillator can be changed.

In some embodiments of the present application, after adjusting a frequency of the first clock signal CLK1 and a frequency of the second clock signal CLK2, the frequency of the first clock signal CLK1 has a first variation ratio relative to the first set frequency, and the frequency of the second clock signal CLK2 has a second variation ratio relative to the second set frequency. A first ratio of the first variation ratio to the first temperature coefficient is equal to a second ratio of the second variation ratio to the second temperature coefficient.

It should be noted that, according to a relationship formula between frequency and temperature, variation frequencies of the first clock signal CLK1 and the second clock signal CLK2 maintain the following relationship: $Δf 1 = f 01 * TC 1 * Δt 1$ $Δf 2 = f 02 * TC 2 * Δt 2$
wherein Δt1 represents an ambient temperature variation of the first clock module corresponding to the first clock signal CLK1, Δt2 represents an ambient temperature variation of the second clock module corresponding to the second clock signal CLK2, Δf1 represents a variation value of the frequency of the first clock signal CLK1 relative to the first set frequency, and Δf2 represents a variation value of the frequency of the second clock signal CLK2 relative to the second set frequency.

Since the first ratio of the first variation ratio to the first temperature coefficient is equal to the second ratio of the second variation ratio to the second temperature coefficient, the variation frequencies of the first clock signal CLK1 and the second clock signal CLK2 also maintain the following relationship: $Δf 1 / f 01 = x 1$ $Δf 2 / f 02 = x 2$ $x 1 / TC 1 = x 2 / TC 2$
wherein x1 represents a variation ratio of the first clock signal CLK1, and x2 represents a variation ratio of the second clock signal CLK2.

Combining the above two calculation formulas for variation frequencies of the first clock signal CLK1 and the second clock signal CLK2 yields: $TC 1 * Δt 1 / TC 1 = TC 2 * Δt 2 / TC 2$

That is, Δt1 = Δt2. If Δt1 and Δt2 represent a difference between an actual ambient temperature and the set temperature, then after adjusting a frequency of the first clock signal CLK1 and a frequency of the second clock signal CLK2 (for example, by adjusting parameters of electronic elements related to temperature coefficients in an RC oscillator), the frequency of the first clock signal CLK1 at this point is equal to the first set frequency at the set temperature, and the frequency of the second clock signal CLK2 is equal to the second set frequency at the set temperature, thereby minimizing/eliminating temperature drift to the first clock signal CLK1 and the second clock signal CLK2.

As an example, suppose the second temperature coefficient of the second clock signal CLK2 is twice the first temperature coefficient of the first clock signal CLK1, the first set frequency of the first clock signal CLK1 is 4 MHz, the second set frequency of the second clock signal CLK2 is 48 MHz, and a ratio between the second clock signal CLK2 and the first clock signal CLK1 at the set temperature is 12. If a temperature drift is presented such that the frequency of the first clock signal CLK1 becomes 4.1 MHz and the frequency of the second clock signal CLK2 becomes 50.4 MHz, a frequency ratio between the first clock signal CLK1 and the second clock signal CLK2 at this point is 12.29. Therefore, by changing the frequency of the first clock signal CLK1 relative to the first set frequency by a first variation ratio of 0.025% while changing the second clock signal CLK2 by a second variation ratio of 0.05%, the frequency of the first clock signal CLK1 can be readjusted to 4 MHz and the frequency of the second clock signal CLK2 to 48 MHz. Simultaneously, since the second temperature coefficient of the second clock signal CLK2 is twice the first temperature coefficient of the first clock signal CLK1, and 0.025% = 0.05%/2, the first ratio of the first variation ratio to the first temperature coefficient is equal to the second ratio of the second variation ratio to the second temperature coefficient.

Thus, the present application enables the frequency of the first clock signal CLK1 to change relative to the first set frequency by a first variation ratio and the frequency of the second clock signal CLK2 to change relative to the second set frequency by a second variation ratio, while ensuring that the first ratio of the first variation ratio to the first temperature coefficient is equal to the second ratio of the second variation ratio to the second temperature coefficient. This allows the frequency of the first clock signal CLK1 and the frequency of the second clock signal CLK2 to maintain a predetermined relationship, ultimately returning the frequency of the first clock signal CLK1 to the first set frequency at the set temperature and the frequency of the second clock signal CLK2 to the second set frequency at the set temperature.

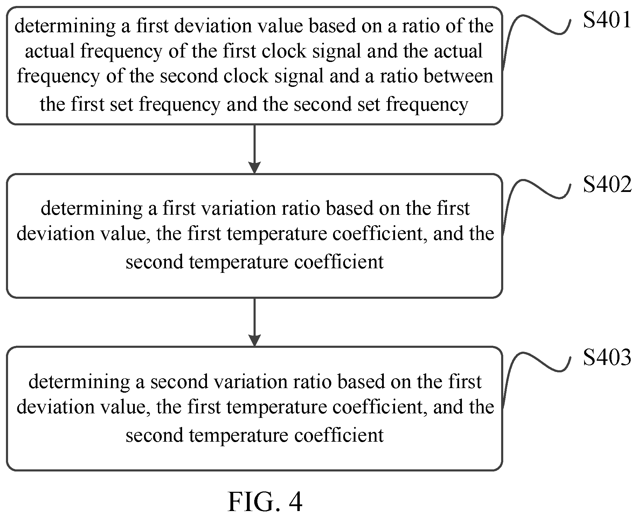

In some embodiments of the present application, continuing to refer to FIG. 4, FIG. 4 shows a flow diagram of adjusting a clock signal frequency in an embodiment of the present application. The step of when a temperature drift is presented in the first clock signal CLK1 and the second clock signal CLK2, adjusting a frequency of the first clock signal CLK1 and a frequency of the second clock signal CLK2 comprises:
Step S401: determining a first deviation value based on a ratio of the actual frequency of the first clock signal CLK1 and the actual frequency of the second clock signal CLK2 and a ratio between the first set frequency and the second set frequency;
In some embodiments of the present application, a ratio of the actual frequency of the first clock signal CLK1 and the actual frequency of the second clock signal CLK2 can be obtained by mutual measurement between the first clock signal CLK1 and the second clock signal CLK2. For example, a number of pulse periods of the second clock signal CLK2 can be measured by the first clock signal CLK1 over a certain number of pulse periods. Assuming that the first clock signal CLK1 measures M pulse periods of the second clock signal CLK2 over N pulse periods, the ratio of the actual frequency of the first clock signal CLK1 and the actual frequency of the second clock signal CLK2 is M/N.

In some embodiments of the present application, a frequency of the first clock signal CLK1 exceeds a frequency of the second clock signal CLK2, facilitating measurement of periods of the low-frequency second clock signal CLK2 using the high-frequency first clock signal CLK1 and obtaining the ratio of the actual frequency of the first clock signal CLK1 and the actual frequency of the second clock signal CLK2. For example, the frequency of the first clock signal CLK1 is 128 MHz, and the frequency of the second clock signal CLK2 is 8 MHz. A single period of the first clock signal CLK1 can measure 16 periods of the second clock signal CLK2, thereby determining the ratio of the actual frequency of the first clock signal CLK1 and the actual frequency of the second clock signal CLK2 as 16.

In some embodiments of the present application, frequencies of the first clock signal CLK1 and the second clock signal CLK2 can also be measured with reference to a reference clock, thereby obtaining the ratio of the actual frequency of the first clock signal CLK1 and the actual frequency of the second clock signal CLK2. For example, the reference clock measures N pulse periods of the first clock signal CLK1 in a single pulse period, while measuring M periods of the second clock signal CLK2 in a single period, yielding a ratio of the actual frequency of the first clock signal CLK1 and the actual frequency of the second clock signal CLK2 of M/N.

After obtaining the ratio of the actual frequency of the first clock signal CLK1 and the actual frequency of the second clock signal CLK2, a first deviation value can be determined in combination with the ratio between the first set frequency and the second set frequency. Generally, a difference between the ratio of the actual frequency of the first clock signal CLK1 and the actual frequency of the second clock signal CLK2 and a set frequency ratio can serve as the first deviation value, that is, the first deviation value D1 can be calculated according to the following formula: $D 1 = \frac{f 01 ∗ \left(1+TC1∗Δt\right)}{f 02 ∗ \left(1+TC2∗Δt\right)} - \frac{f 01}{f 02}$

Let a ratio between the first set frequency and the second set frequency be N0. After simplification: $D 1 = N 0 ∗ \frac{\left(1+TC1∗Δt\right)}{\left(1+TC2∗Δt\right)} - N 0$ $D 1 = N 0 ∗ \frac{\left(1+TC1∗Δt\right) ∗ \left(1-TC2∗Δt\right)}{\left(1+TC2∗Δt\right) ∗ \left(1-TC2∗Δt\right)} - N 0$ $D 1 = N 0 ∗ \frac{\left(1+TC1∗Δt-TC2∗Δt-TC1∗Δt∗TC2∗Δt\right)}{1 - {TC 2}^{2} ∗ {Δt}^{2}} - N 0$
wherein secondary terms are minimal.

Thus, the simplified first deviation value D1 can be calculated according to the following formula: $D 1 = N 0 ∗ \frac{\left(1+TC1∗Δt-TC2∗Δt\right)}{1} - N 0$

That is: $D 1 = \left(TC1-TC2\right) * Δt$

It can be seen that, since the first temperature coefficient is different from the second temperature coefficient, the first deviation value D varies with temperature. In other words, a one-to-one correspondence exists between the frequency ratio of the first clock signal CLK1 and the second clock signal CLK2 and temperature. The first deviation value characterizes a temperature drift parameter of the first clock signal CLK1 and the second clock signal CLK2 relative to the set temperature. Therefore, a high-precision temperature drift parameter can be obtained based on the frequency ratio between the first clock signal CLK1 and the second clock signal CLK2 without a temperature sensor.

Understandably, the ratio of the actual frequency of the first clock signal CLK1 and the actual frequency of the second clock signal CLK2 and the set frequency ratio can undergo corresponding mathematical processing to obtain the first deviation value. For example, the first deviation value can be rounded to yield an integer first deviation value. As another example, the ratio of the actual frequency of the first clock signal CLK1 and the actual frequency of the second clock signal CLK2 can be measured multiple times, differences between multiple ratios of the actual frequencies and the set frequency ratio calculated, and finally the first deviation value obtained by averaging or processing multiple differences.

In some embodiments of the present application, one of the first clock signal CLK1 and the second clock signal CLK2 has a positive temperature coefficient, while the other has a negative temperature coefficient. Combined with the calculation formula for the first deviation value D1: D1=(TC1-TC2)*Δt, when temperature varies, the first deviation value becomes larger, rendering the first deviation value D1 more sensitive to temperature and facilitating improved sensitivity of the clock signal temperature drift elimination method in the present application.

Step S402: determining a first variation ratio based on the first deviation value, the first temperature coefficient, and the second temperature coefficient;
Specifically, according to a variation frequency of a clock signal, a calculation formula for the first deviation value D, and a calculation formula for a first variation ratio x1 of the first clock signal CLK1: $Δf 1 = f 01 * TC 1 * Δt$ $Δt = D 1 \left(TC1-TC2\right)$ $x 1 = Δf 1 / f 01$
yields: $x 1 = TC 1 * D 1 / \left(TC1-TC2\right)$

It can be seen that, since the first deviation value characterizes a temperature drift parameter of the first clock signal CLK1 relative to the set temperature, the first variation ratio of the first clock signal CLK1 can be determined based on the first deviation value, the first temperature coefficient, and the second temperature coefficient, facilitating change of the first clock signal CLK1 relative to the first set frequency by the first variation ratio and ultimately returning the frequency of the first clock signal CLK1 to the first set frequency at the set temperature.

Step S403: determining a second variation ratio based on the first deviation value, the first temperature coefficient, and the second temperature coefficient.

Similarly, according to a variation frequency of a clock signal, a calculation formula for the first deviation value D1, and a calculation formula for a second variation ratio x2 of the second clock signal CLK2, yields: $x 2 = TC 2 * D 1 / \left(TC1-TC2\right)$

It can be seen that, since the first deviation value characterizes a temperature drift parameter of the second clock signal CLK2 relative to the set temperature, the second variation ratio of the second clock signal CLK2 can be determined based on the first deviation value, the first temperature coefficient, and the second temperature coefficient, facilitating change of the second clock signal CLK2 relative to the second set frequency by the second variation ratio and ultimately returning the frequency of the second clock signal CLK2 to the second set frequency at the set temperature.

It should be noted that, according to the calculation formula for the first deviation value D1: D1=(TC1-TC2)*Δt, the above embodiment primarily addresses frequency variation portions of clock signals due to first-order temperature coefficients, whereas actual frequency variations of clock signals upon temperature change also include portions due to higher-order temperature coefficients, for example, second-order temperature coefficient terms, including TC22 *Δt2 and TC1*Δt*TC2*Δt, omitted in the derivation of the first deviation value D1. To further eliminate frequency variation portions corresponding to higher-order temperature coefficients, refer to the following content:

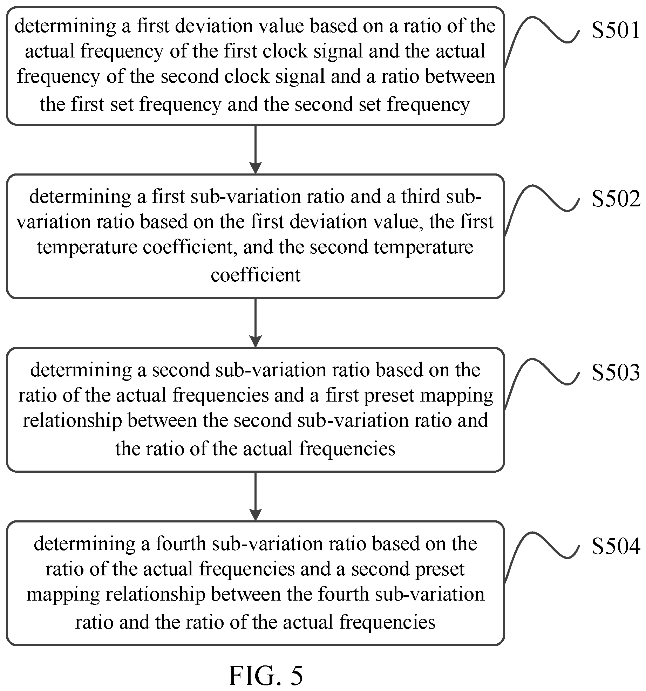

In some embodiments of the present application, a first variation ratio comprises a first sub-variation ratio and a second sub-variation ratio, and a second variation ratio comprises a third sub-variation ratio and a fourth sub-variation ratio. The first sub-variation ratio and the third sub-variation ratio are influenced by a first-order temperature coefficient, while the second sub-variation ratio and the fourth sub-variation ratio are influenced by a higher-order temperature. With reference to FIG. 5, FIG. 5 shows another flow diagram of adjusting a clock signal frequency in an embodiment of the present application. The step of when a temperature drift is presented in the first clock signal CLK1 and the second clock signal CLK2, adjusting a frequency of the first clock signal CLK1 and a frequency of the second clock signal CLK2 comprises:
Step S501: determining a first deviation value based on a ratio of the actual frequency of the first clock signal CLK1 and the actual frequency of the second clock signal CLK2 and a ratio between the first set frequency and the second set frequency;
Step S502: determining a first sub-variation ratio and a third sub-variation ratio based on the first deviation value, the first temperature coefficient, and the second temperature coefficient;
Step S503: determining a second sub-variation ratio based on the ratio of the actual frequencies and a first preset mapping relationship between the second sub-variation ratio and the ratio of the actual frequencies; and
Step S504: determining a fourth sub-variation ratio based on the ratio of the actual frequencies and a second preset mapping relationship between the fourth sub-variation ratio and the ratio of the actual frequencies.

Specifically, the first sub-variation ratio and the third sub-variation ratio are influenced by a first-order temperature coefficient, while the second sub-variation ratio and the fourth sub-variation ratio are influenced by a higher-order (for example, second-order) temperature coefficient. Taking the first clock signal CLK1 as an example, when considering influence of a higher-order (for example, second-order) temperature coefficient, a relationship between a variation frequency of the first clock signal CLK1 and temperature can be calculated according to the following relationship: $Δf 1 = f 01 * Δt * N 1 + f 01 * Δt * N 2$
wherein N1 represents a first-order temperature coefficient, N2 represents a higher-order temperature coefficient, Δt*N1 represents the first sub-variation ratio, and Δt*N2 represents the third sub-variation ratio.

For the first sub-variation ratio and the third sub-variation ratio, combined with the above calculation formula for the first deviation value, the first sub-variation ratio and the third sub-variation ratio can be calculated according to the following formulas: $x 11 = TC 1 * D 1 / \left(TC1-TC2\right)$ $x 21 = TC 2 * D 1 / \left(TC1-TC2\right)$
wherein x11 represents the first sub-variation ratio, and x21 represents the third sub-variation ratio.

For the second sub-variation ratio and the fourth sub-variation ratio, since the second sub-variation ratio and the fourth sub-variation ratio are influenced by a higher-order (for example, second-order) temperature coefficient, the second sub-variation ratio and the fourth sub-variation ratio can be obtained respectively by querying a first preset mapping relationship and a second preset mapping relationship. The first preset mapping relationship refers to a pre-calibrated data set of relationships between the second sub-variation ratio and the ratio of the actual frequencies, and the second preset mapping relationship refers to a pre-calibrated data set of relationships between the fourth sub-variation ratio and the ratio of the actual frequencies.

After determining the ratio of the actual frequency of the first clock signal CLK1 and the actual frequency of the second clock signal CLK2, the first sub-variation ratio is calculated using the above formulas, and the second sub-variation ratio can be determined by querying the first preset mapping relationship. Combining the first sub-variation ratio and the second sub-variation ratio to comprehensively adjust the frequency of the first clock signal CLK1 facilitates complete elimination of influences from both first-order and higher-order temperature coefficients, thereby enabling more accurate return of the frequency of the first clock signal CLK1 to the frequency at the set temperature.

As an example, suppose the first set frequency of the first clock signal CLK1 at a set temperature of 25°C. is 2 MHz. By counting periods of the second clock signal CLK2 using the first clock signal CLK1, the ratio of the actual frequency of the first clock signal CLK1 and the actual frequency of the second clock signal CLK2 is determined as 12.5 (indicating an ambient temperature of 30°C.). The first sub-variation ratio is calculated as 5%, and a corresponding second sub-variation ratio in the first preset mapping relationship is 1%. Thus, the first variation ratio by which the frequency of the first clock signal CLK1 needs to change is 6% to return the frequency of the first clock signal CLK1 to 2 MHz. The same applies to the second clock signal CLK2, which is not repeated here.

Thus, the present application utilizes pre-calibrated first preset mapping relationship and second preset mapping relationship to further eliminate influences of higher-order temperature coefficients, thereby enabling more accurate return of frequencies of the first clock signal CLK1 and the second clock signal CLK2 to frequencies at the set temperature.

Understandably, the first preset mapping relationship may also be a data set of relationships between the first sub-variation ratio and the ratio of the actual frequencies, and the second preset mapping relationship may also be a data set of relationships between the third sub-variation ratio and the ratio of the actual frequencies. That is, the first preset mapping relationship can determine a variation ratio of the first clock signal CLK1 regarding a first-order temperature coefficient. Since frequency variations of clock signals are primarily influenced by first-order temperature coefficients, this can also enable accurate return of the frequency of the first clock signal CLK1 to the first set frequency at the set temperature. Alternatively, the first preset mapping relationship and the second preset mapping relationship simultaneously include frequency variation ratios corresponding to both first-order and higher-order temperature coefficients. That is, the first preset mapping relationship and the second preset mapping relationship comprise pre-tested and calibrated results including frequency variation ratios corresponding to first-order and higher-order temperature coefficients. Thus, the first preset mapping relationship and the second preset mapping relationship can directly eliminate influences of both first-order and higher-order temperature coefficients simultaneously, thereby enabling more accurate return of frequencies of the first clock signal CLK1 and the second clock signal CLK2 to frequencies at the set temperature.

In some embodiments of the present application, a second deviation value can also be determined based on an actual frequency difference and a set frequency difference between the first clock signal CLK1 and the second clock signal CLK2. Then, a first variation ratio and a second variation ratio are determined based on the second deviation value, the first temperature coefficient, and the second temperature coefficient. Similarly, since the first temperature coefficient is different from the second temperature coefficient, the second deviation value also varies with temperature and characterizes a temperature drift parameter of the first clock signal CLK1 and the second clock signal CLK2 relative to the set temperature. Therefore, a first variation ratio of the first clock signal CLK1 and a second variation ratio of the second clock signal CLK2 can be determined respectively based on the second deviation value, the first temperature coefficient, and the second temperature coefficient.

In some embodiments of the present application, after determining a first variation ratio of the first clock signal CLK1, a frequency of the first clock signal CLK1 can be directly adjusted to change by the first variation ratio. In other embodiments of the present application, after determining a first variation ratio of the first clock signal CLK1, the frequency of the first clock signal CLK1 can be adjusted in multiple steps to reach the first variation ratio. For example, after a temperature drift is presented, the first variation ratio of the frequency of the first clock signal CLK1 relative to the first set frequency is 0.25%. The frequency of the first clock signal CLK1 can first be changed from 1.0025 times the first set frequency to 1.0015 times the first set frequency, and then further changed from 1.0015 times the first set frequency to the first set frequency. Understandably, adjustment of the frequency of the second clock signal CLK2 can follow the above approach, which is not repeated here.

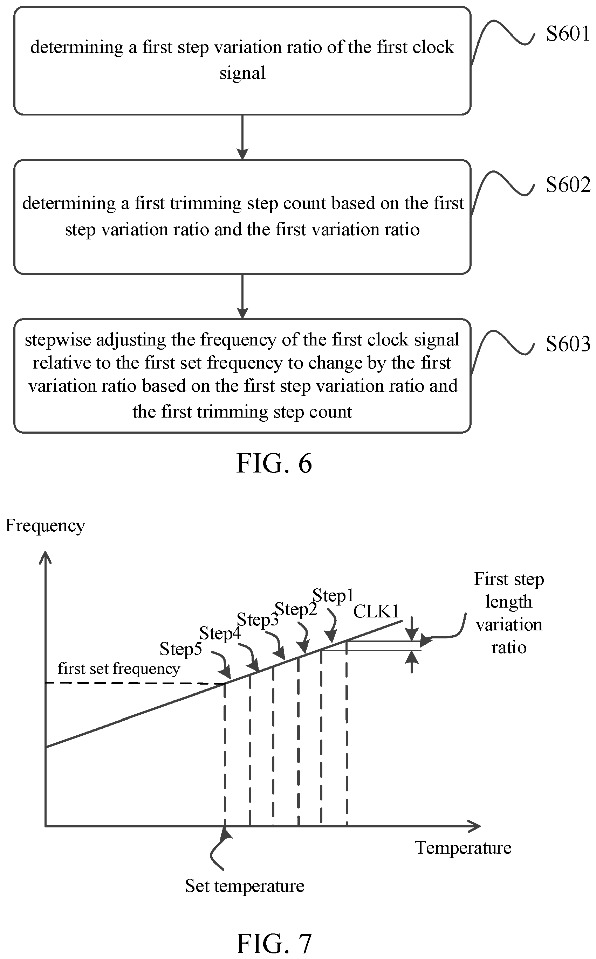

In some embodiments of the present application, for example, in an embodiment involving multi-step adjustment of the frequency of the first clock signal CLK1 to a first variation ratio, with reference to FIG. 6, FIG. 6 shows another flow diagram of adjusting a clock signal frequency in an embodiment of the present application. The step of adjusting the frequency of the first clock signal CLK1 comprises:
Step S601: determining a first step length variation ratio of the first clock signal CLK1;
Specifically, the first step length variation ratio represents a change ratio of the frequency of the first clock signal CLK1 relative to the first set frequency in each adjustment step of the first clock signal CLK1, for example, 0.05% or 0.01% of the first set frequency as the first variation ratio. In some embodiments of the present application, the first step length variation ratio can be determined based on parameters of electronic elements in the first clock module. For example, in an embodiment where frequency is adjusted by trimming capacitors in an RC oscillator, the first step length variation ratio can be determined based on a minimum unit capacitance in a capacitor array. In some embodiments of the present application, the first step length variation ratio can be determined based on a temperature coefficient to set a frequency trimming step. For example, when temperature changes by 1°C, the frequency of the first clock signal CLK1 changes by 0.5% relative to the first set frequency, so the frequency of the first clock signal CLK1 can be adjusted with a first step length variation ratio of 0.1%.

Understandably, the first step length variation ratio can be adjusted according to actual needs, without specific limitations herein in the present application.

Step S602: determining a first trimming step count based on the first step length variation ratio and the first variation ratio;
After determining the first step length variation ratio, a first trimming step count can be determined based on the first step length variation ratio and the first variation ratio. For example, if the first variation ratio is 0.5% and the first step length variation ratio is 0.1%, the first trimming step count can be determined as 5 steps. In some embodiments of the present application, when determining the first trimming step count, if the first variation ratio and the first step length variation ratio are not integer multiples, a ratio of the first variation ratio to the first step length variation ratio can be rounded. For example, if the first variation ratio is 0.41% and the first step length variation ratio is 0.2%, the first trimming step count can be determined as 2 steps.

Understandably, a smaller first step length variation ratio more readily makes the first variation ratio and the first step length variation ratio integer multiples, thereby enabling precise adjustment of the frequency of the first clock signal CLK1 to the first set frequency. Therefore, where permitted by electronic elements in the first clock module, a smaller first step length variation ratio should be set as much as possible.

Step S603: stepwise adjusting the frequency of the first clock signal CLK1 relative to the first set frequency to change by the first variation ratio based on the first step length variation ratio and the first trimming step count.

After determining the first step length variation ratio and the first trimming step count, the frequency of the first clock signal CLK1 can be stepwise adjusted relative to the first set frequency to change by the first variation ratio. For example, with reference to FIG. 7, FIG. 7 shows a schematic diagram of a process of adjusting the frequency of the first clock signal CLK1 in an embodiment of the present application. With a first variation ratio of 0.5% and a first step length variation ratio of 0.1%, the frequency of the first clock signal CLK1 returns to the first set frequency after 5 steps.

Understandably, during adjustment of the frequency of the first clock signal CLK1 to the first set frequency, frequency ratios in each step may also be unequal. For example, with a first variation ratio of 1%, the frequency of the first clock signal CLK1 can sequentially change by 0.4%, 0.3%, 0.2%, and 0.1% over 4 steps to ultimately return to the first set frequency.

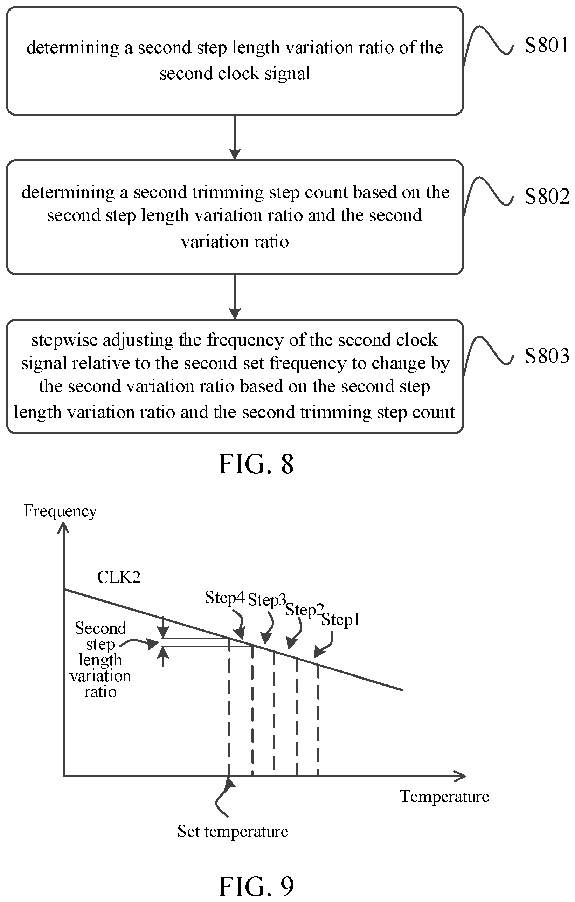

In some embodiments of the present application, for example, in an embodiment involving multi-step adjustment of the frequency of the second clock signal CLK2 to a second variation ratio, with reference to FIG. 8, FIG. 8 shows another flow diagram of adjusting a clock signal frequency in an embodiment of the present application. The step of adjusting the frequency of the second clock signal CLK2 comprises:
Step S801: determining a second step length variation ratio of the second clock signal CLK2;
Specifically, the second step length variation ratio represents a change ratio of the frequency of the second clock signal CLK2 relative to the second set frequency in each adjustment step of the second clock signal CLK2, for example, 0.05% or 0.01% of the first set frequency as the second variation ratio. In some embodiments of the present application, the second step length variation ratio can be determined based on parameters of electronic elements in the second clock module. For example, in an RC oscillator where frequency is adjusted by trimming resistors, the second step length variation ratio can be determined based on a minimum unit resistance in a resistor array. In some embodiments of the present application, the second step length variation ratio can be determined based on a temperature coefficient to set a frequency trimming step. For example, when temperature changes by 1°C, the frequency of the second clock signal CLK2 changes by 0.4% relative to the second set frequency, so the frequency of the first clock signal CLK1 can be adjusted with a first step length variation ratio of 0.2%.

Step S802: determining a second trimming step count based on the second step length variation ratio and the second variation ratio;
After determining the second step length variation ratio, a second trimming step count can be determined based on the second step length variation ratio and the second variation ratio. For example, if the second variation ratio is 0.4% and the second step length variation ratio is 0.2%, the second trimming step count can be determined as 2 steps. In some embodiments of the present application, when determining the second trimming step count, if the second variation ratio and the second step length variation ratio are not integer multiples, a ratio of the second variation ratio to the second step length variation ratio can be rounded. For example, if the second variation ratio is 0.62% and the first step length variation ratio is 0.1%, the first trimming step count can be determined as 3 steps.

Understandably, a smaller second step length variation ratio more readily makes the second variation ratio and the second step length variation ratio integer multiples, thereby enabling precise adjustment of the frequency of the second clock signal CLK2 to the second set frequency.

Step S803: stepwise adjusting the frequency of the second clock signal CLK2 relative to the second set frequency to change by the second variation ratio based on the second step length variation ratio and the second trimming step count.

After determining the second step length variation ratio and the second trimming step count, the frequency of the second clock signal CLK2 can be stepwise adjusted relative to the second set frequency to change by the second variation ratio. For example, with reference to FIG. 9, FIG. 9 shows a schematic diagram of a process of adjusting the frequency of the second clock signal CLK2 in an embodiment of the present application. With a second variation ratio of 0.8% and a second step length variation ratio of 0.2%, the frequency of the second clock signal CLK2 returns to the second set frequency after 4 steps.

Understandably, during adjustment of the frequency of the second clock signal CLK1 to the second set frequency, frequency ratios in each step may also be unequal. For example, with a second variation ratio of 0.6%, the frequency of the second clock signal CLK2 can sequentially change by 0.3%, 0.2%, and 0.1% over 3 steps to ultimately return to the second set frequency.

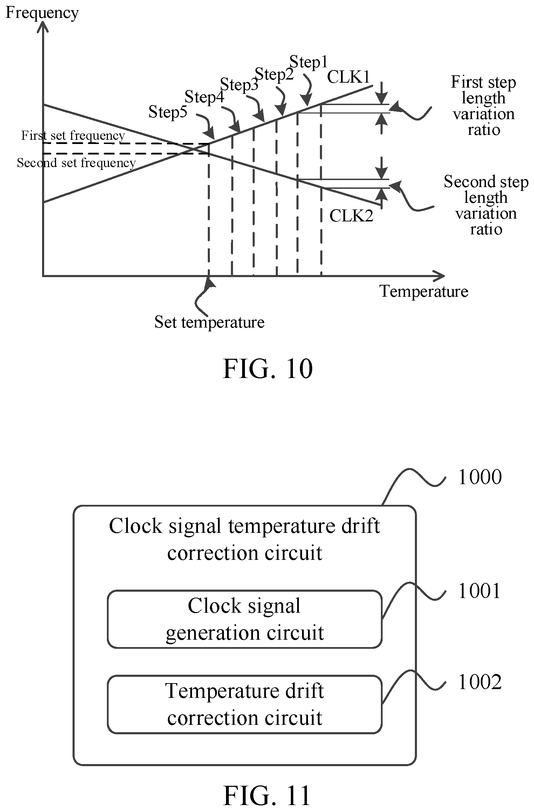

In some embodiments of the present application, continuing to refer to FIG. 10, FIG. 10 shows a schematic diagram of a process of adjusting frequencies of the first clock signal CLK1 and the second clock signal CLK2 in an embodiment of the present application, wherein a first trimming step count is equal to a second trimming step count. Specifically, since the first variation ratio, the first step length variation ratio, and the first trimming step count, as well as the second variation ratio, the second step length variation ratio, and the second trimming step count maintain the following relationship: $x 11 = x 1 / N 1$ $x 21 = x 2 / N 2$
wherein N1 represents the first trimming step count, N2 represents the second trimming step count, x11 represents the first step length variation ratio, and x21 represents the second step length variation ratio.

Simultaneously, according to a calculation formula for variation frequencies of clock signals: $x 11 = TC 1 * Δt 01$ $x 21 = TC 2 * Δt 02$
wherein Δt01 represents a temperature change value corresponding to each change of the first clock signal CLK1 by the first step length variation ratio, and Δt02 represents a temperature change value corresponding to each change of the second clock signal CLK2 by the second step length variation ratio.

From the above relationships, it follows that: $N 1 = x 1 / TC 1 * Δt 01$ $N 2 = x 2 / TC 2 * Δt 02$

Since the first trimming step count is equal to the second trimming step count: $x 1 / TC 1 * Δt 01 = x 2 / TC 2 * Δt 02$

In embodiments of the present application, since the first ratio of the first variation ratio to the first temperature coefficient is equal to the second ratio of the second variation ratio to the second temperature coefficient, Δt01=Δt02. That is, when the first trimming step count is equal to the second trimming step count, during adjustment of frequencies of the first clock signal CLK1 and the second clock signal CLK2, adjustment processes of the first clock signal CLK1 and the second clock signal CLK2 are synchronized in terms of temperature, facilitating consistency in temperature during frequency adjustment of the first clock signal CLK1 and the second clock signal CLK2.

Embodiments of the present application further provide a clock signal temperature drift correction circuit 1000. With reference to FIG. 11, FIG. 11 shows a block diagram of the clock signal temperature drift correction circuit 1000 in an embodiment of the present application. The clock signal temperature drift correction circuit 1000 comprises:
a clock signal generation circuit 1001, wherein the clock signal generation circuit 1001 comprises a first clock module generating a first clock signal CLK1 and a second clock module generating a second clock signal CLK2;
a temperature drift correction circuit 1002, wherein the temperature drift correction circuit 1002 is configured to determine if a temperature drift is presented in the first clock signal CLK1 and the second clock signal CLK2, and when a temperature drift is presented in the first clock signal CLK1 and the second clock signal CLK2, the temperature drift correction circuit 1002 adjusts a frequency of the first clock signal CLK1 and a frequency of the second clock signal CLK2 so that the frequency of the first clock signal CLK1 and the frequency of the second clock signal CLK2 maintain a predetermined relationship;
wherein a first temperature coefficient of the first clock signal CLK1 is different from a second temperature coefficient of the second clock signal CLK2, and when the frequency of the first clock signal CLK1 and the frequency of the second clock signal CLK2 maintain the predetermined relationship, the frequency of the first clock signal CLK1 is equal to a first set frequency at a set temperature, and the frequency of the second clock signal CLK2 is equal to a second set frequency at the set temperature.

In the clock signal temperature drift correction circuit provided by embodiments of the present application, since a first temperature coefficient of a first clock signal CLK1 is different from a second temperature coefficient of a second clock signal CLK2, when a temperature change causes variations in a frequency of the first clock signal CLK1 and a frequency of the second clock signal CLK2, a relationship between the frequency of the first clock signal CLK1 and the frequency of the second clock signal CLK2 varies. For example, when the first temperature coefficient exceeds the second temperature coefficient, a frequency difference/ratio between the first clock signal CLK1 and the second clock signal CLK2 gradually increases as temperature rises. Therefore, by ensuring that the frequency of the first clock signal CLK1 and the frequency of the second clock signal CLK2 maintain a predetermined relationship again after a temperature drift is presented, the frequency of the first clock signal CLK1 can return to a first set frequency at a set temperature, and the frequency of the second clock signal can return to a second set frequency at the set temperature. This allows the first clock signal CLK1 and the second clock signal CLK2 to return to corresponding set frequencies after an ambient temperature change even if a temperature drift is presented, to ultimately minimize/eliminate temperature drift for the first clock signal CLK1 and the second clock signal CLK2, and avoiding the temperature drift of the clock signal that cannot be completely eliminated in conventional approaches due to objective factors such as circuit fabrication processes and accuracy of temperature sensors.

Embodiments of the present application further provide a chip comprising the above clock signal temperature drift correction circuit. An integrated circuit (IC) chip, also known as a chip, and the chip may include, but is not limited to, a system on chip (SOC) chip or a system in package (SIP) chip. Since the chip in embodiments of the present application comprises the above clock signal temperature drift correction circuit, the chip possesses all advantageous effects of the above clock signal temperature drift correction circuit, which are not repeated here in the present application.

Embodiments of the present application further provide an electronic device comprising a memory and a processor. The memory stores a computer program, and the processor is configured to execute the computer program in the memory to perform steps in the clock signal temperature drift correction method described in any of the above embodiments. The electronic device may include, but is not limited to, a body scale, a body fat scale, a nutrition scale, an infrared electronic thermometer, a pulse oximeter, a body composition analyzer, a mobile power bank, a wireless charger, a fast charger, a car charger, an adapter, a display, a USB (Universal Serial Bus) hub, a stylus, a true wireless earphone, an automotive central control screen, an automobile, a smart wearable device, a mobile terminal, or a smart home device. Smart wearable devices include, but are not limited to, smart watches, smart bands, and cervical massagers. Mobile terminals include, but are not limited to, smartphones, laptops, tablets, and POS (point of sales terminal) machines. Smart home devices include, but are not limited to, smart sockets, smart rice cookers, smart robotic vacuum cleaners, and smart lamps.

The above descriptions represent only preferred embodiments of the present application and do not impose any formal limitations thereon. Although the present application has been disclosed with reference to preferred embodiments, these are not intended to limit the present application. Any person skilled in the art, without departing from the scope of the technical solution of the present application, may make slight changes or modifications using the technical content disclosed above to produce equivalent embodiments with equivalent variations. However, any simple modifications, equivalent changes, and alterations made to the above embodiments according to the technical essence of the present application, without departing from the content of the technical solution of the present application, still fall within the scope of the technical solution of the present application.

## Claims

1. A clock signal temperature drift correction method, **characterized in that** clock signal temperature drift correction method is applied to a clock signal generation circuit, the clock signal generation circuit comprises a first clock module generating a first clock signal and a second clock module generating a second clock signal, and the method comprises:
determining if a temperature drift is presented in the first clock signal and the second clock signal; and
when a temperature drift is presented in the first clock signal and the second clock signal, adjusting a frequency of the first clock signal and a frequency of the second clock signal so that the frequency of the first clock signal and the frequency of the second clock signal maintain a predetermined relationship;
wherein a first temperature coefficient of the first clock signal is different from a second temperature coefficient of the second clock signal, and when the frequency of the first clock signal and the frequency of the second clock signal maintain the predetermined relationship, the frequency of the first clock signal is equal to a first set frequency at a set temperature, and the frequency of the second clock signal is equal to a second set frequency at the set temperature.

2. The clock signal temperature drift correction method according to claim 1, **characterized in that** after the step of adjusting the frequency of the first clock signal and the frequency of the second clock signal, the frequency of the first clock signal has a first variation ratio relative to the first set frequency, and the frequency of the second clock signal has a second variation ratio relative to the second set frequency;
wherein a first ratio of the first variation ratio to the first temperature coefficient is equal to a second ratio of the second variation ratio to the second temperature coefficient.

3. The clock signal temperature drift correction method according to claim 2, **characterized in that** the step of when a temperature drift is presented in the first clock signal and the second clock signal, adjusting the frequency of the first clock signal and the frequency of the second clock signal comprises:
determining a first deviation value based on a ratio of the actual frequency of the first clock signal to the actual frequency of the second clock signal and a ratio between the first set frequency and the second set frequency;
determining the first variation ratio based on the first deviation value, the first temperature coefficient, and the second temperature coefficient; and
determining the second variation ratio based on the first deviation value, the first temperature coefficient, and the second temperature coefficient.

4. The clock signal temperature drift correction method according to claim 2, **characterized in that** the first variation ratio comprises a first sub-variation ratio and a second sub-variation ratio, the second variation ratio comprises a third sub-variation ratio and a fourth sub-variation ratio, the first sub-variation ratio and the third sub-variation ratio are influenced by a first-order temperature coefficient, and the second sub-variation ratio and the fourth sub-variation ratio are influenced by a higher-order temperature;
the step of when a temperature drift is presented in the first clock signal and the second clock signal, adjusting the frequency of the first clock signal and the frequency of the second clock signal comprises:
determining a first deviation value based on a ratio of the actual frequency of the first clock signal to the actual frequency of the second clock signal and a ratio between the first set frequency and the second set frequency;
determining the first sub-variation ratio and the third sub-variation ratio based on the first deviation value, the first temperature coefficient, and the second temperature coefficient;
determining the second sub-variation ratio based on the ratio of the actual frequencies and a first preset mapping relationship between the second sub-variation ratio and the ratio of the actual frequencies; and
determining the fourth sub-variation ratio based on the ratio of the actual frequencies and a second preset mapping relationship between the fourth sub-variation ratio and the ratio of the actual frequencies.

5. The clock signal temperature drift correction method according to claim 3 or 4, **characterized in that** the step of when a temperature drift is presented in the first clock signal and the second clock signal, adjusting the frequency of the first clock signal and the frequency of the second clock signal further comprises:
determining a first step length variation ratio of the first clock signal;
determining a first trimming step count based on the first step length variation ratio and the first variation ratio; and
stepwise adjusting the frequency of the first clock signal relative to the first set frequency to change by the first variation ratio based on the first step length variation ratio and the first trimming step count.

6. The clock signal temperature drift correction method according to claim 5, **characterized in that** the step of when a temperature drift is presented in the first clock signal and the second clock signal, adjusting the frequency of the first clock signal and the frequency of the second clock signal further comprises:
determining a second step length variation ratio of the second clock signal;
determining a second trimming step count based on the second step length variation ratio and the second variation ratio; and
stepwise adjusting the frequency of the second clock signal relative to the second set frequency to change by the second variation ratio based on the second step length variation ratio and the second trimming step count.

7. The clock signal temperature drift correction method according to claim 6, **characterized in that** the first trimming step count is equal to the second trimming step count.

8. The clock signal temperature drift correction method according to claim 1, **characterized in that** the step of determining if a temperature drift is presented in the first clock signal and the second clock signal comprises:
determining if a temperature drift is presented in the first clock signal and the second clock signal based on a ratio of the actual frequency of the first clock signal to the actual frequency of the second clock signal and a ratio between the first set frequency and the second set frequency.

9. The clock signal temperature drift correction method according to claim 1, **characterized in that** one of the first clock signal and the second clock signal has a positive temperature coefficient, and the other has a negative temperature coefficient.

10. The clock signal temperature drift correction method according to claim 1, **characterized in that** a frequency of the first clock signal exceeds a frequency of the second clock signal.

11. The clock signal temperature drift correction method according to claim 1, **characterized in that** the predetermined relationship comprises a ratio of the actual frequency of the first clock signal to the actual frequency of the second clock signal equal to a set frequency ratio, and the set frequency ratio is equal to a ratio between the first set frequency and the second set frequency; or
the predetermined relationship comprises a difference between the actual frequency of the first clock signal and the actual frequency of the second clock signal equal to a set frequency difference, and the set frequency difference is equal to a difference between the first set frequency and the second set frequency.

12. A clock signal temperature drift correction circuit, **characterized in** comprising:
a clock signal generation circuit comprising a first clock module generating a first clock signal and a second clock module generating a second clock signal; and
a temperature drift correction circuit configured to determine if a temperature drift is presented in the first clock signal and the second clock signal, wherein when a temperature drift is presented in the first clock signal and the second clock signal, the temperature drift correction circuit adjusts a frequency of the first clock signal and a frequency of the second clock signal so that the frequency of the first clock signal and the frequency of the second clock signal maintain a predetermined relationship;
wherein a first temperature coefficient of the first clock signal is different from a second temperature coefficient of the second clock signal, and when the frequency of the first clock signal and the frequency of the second clock signal maintain the predetermined relationship, the frequency of the first clock signal is equal to a first set frequency at a set temperature, and the frequency of the second clock signal is equal to a second set frequency at the set temperature.

13. A chip, **characterized in** comprising the clock signal temperature drift correction circuit according to claim 12.

14. An electronic device, **characterized in** comprising a memory and a processor, **characterized in that** the memory stores a computer program, and the processor is configured to execute the computer program in the memory to perform steps in the clock signal temperature drift correction method according to any one of claims 1 to 11.
